# EUROPÄISCHE PATENTSCHRIFT

(11) **EP 2 828 973 B1**
(45) Veröffentlichungstag und Bekanntmachung des Hinweises auf die Patenterteilung: **08.01.2020**
(21) Anmeldenummer: 13708467.9
(22) Anmeldetag: 12.03.2013
(51) Int. Cl.: H03K 17/955

(54) **KAPAZITIVE SENSORANORDNUNG ZUR SCHALTUNG EINER TÜRÖFFNUNG AN EINEM KRAFTFAHRZEUG UND ZUGEHÖRIGES VERFAHREN**
CAPACITIVE SENSOR ARRANGEMENT FOR SWITCHING A DOOR OPENING IN A MOTOR VEHICLE AND ASSOCIATED METHOD
SYSTÈME DE CAPTEUR CAPACITIF POUR COMMANDER L'OUVERTURE D'UNE PORTE DE VÉHICULE À MOTEUR ET PROCÉDÉ CORRESPONDANT

(30) Priorität: 21.03.2012 DE 102012102422
(43) Veröffentlichungstag der Anmeldung: 28.01.2015
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Zenz Patentanwälte Partnerschaft mbB
(86) Internationale Anmeldenummer: PCT/EP2013/054922
(87) Internationale Veröffentlichungsnummer: WO 2013/139637

(56) Entgegenhaltungen:
- WO-A1-2010/095513
- DE-A1-102010 006 621

## Beschreibung

Die Erfindung betrifft eine kapazitive Sensoranordnung mit einer Sensorelektrode, mit deren Hilfe das Eindringen eines Objekts in einen Raum vor der Sensorelektrode erfasst wird.

Ein Sensor der vorgenannten Art nutzt das kapazitive Messprinzip, um einen sich nähernden Gegenstand oder ein Hindernis zu erkennen. Hierzu wird mittels zweier Elektroden ein äußeres elektrisches Feld aufgebaut. Tritt in dieses elektrische Feld ein Dielektrikum ein, so verändert sich die Kapazität des von den Elektroden gebildeten Kondensators.

Eine mit der Sensorelektrode gekoppelte Steuer- und Auswerteschaltung erfasst eine Änderung der Kapazität der Sensorelektrode gegenüber einem Referenzpotential, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet.

Die Sensorelektrode reagiert dabei auf Annäherungen bzw. Berührungen von Objekten durch eine Kapazitätsänderung des aus der Sensorelektrode und dem Objekt gebildeten Kondensators. Dies lässt sich im Kern darauf zurückführen, dass die Kapazität eines Kondensators von seinem Plattenabstand abhängt. Im Regelfall erhöht sich dessen Kapazität je näher das Objekt der Sensorelektrode kommt.

Eine derartige kapazitive Sensoranordnung ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Bei kapazitiven Sensoren werden Kapazitätsänderungen auch als Variationen der Auflade- und/oder Entladezeit der Kapazität einer Sensorelektrode ermittelt. Beispielsweise arbeitet der Sensor nach dem Ladungstransferprinzip. Eine Auswerteelektronik nach dem Ladungstransferprinzip benötigt dabei wenigstens einen Referenzkondensator welcher turnusmäßig aufgeladen wird, wobei die Aufladezeit bestimmt wird und als Referenzzeitspanne für die Auswertung von Annäherungen oder Berührungen eines Objektes verwendet wird. Es werden also Änderungen der Aufladezeit des Referenzkondensators ausgewertet, die durch Annäherungen eines Objektes an die Sensorelektrode modifiziert werden.

Die Sensoranordnungen können durch Anordnung und Schaltung weiterer Wirkkomponenten, z.B. weiterer potenzialkontrollierter Elektroden verbessert werden. Um Störeinflüsse zu reduzieren und die Empfindlichkeit eines solchen Sensors zu erhöhen ist es bekannt, den Sensor mit einer als Abschirmung wirksamen zusätzlichen Elektrode als kapazitiven Näherungssensor auszuführen. Ein solcher, auch als Capaciflector bezeichneter Sensor ist aus der WO 99/48730 oder aus der DE 40 36 465 Alfür den Einsatz als Einklemmschutz eines Fensterhebers eines Kraftfahrzeuges prinzipiell bekannt. Ein Capaciflector als kapazitiver Sensor mit dreischichtigem Elektrodenaufbau, der als Teil einer Dichtungsanordnung beispielsweise in ein strangförmiges Trägermaterial eingebracht ist, ist aus der DE 10 2006 053 572 B3 bekannt.

Eine kapazitive Sensoranordnung mit einer Sensorelektrode, mit einer beabstandet hinter der Sensorelektrode angeordneten Masse-Hintergrundelektrode und mit einer Schirmelektrode, die zwischen der Sensorelektrode und der Masse-Hintergrundelektrode angeordnet ist und die über eine Steuer- und Auswerteschaltung derart mit der Sensorelektrode gekoppelt ist, dass ihr Potential dem Potential der Sensorelektrode nachgeführt wird, ist außerdem aus den Veröffentlichungen EP 0 518 836 A1, US 6,825,752 B2, DE 101 31 243 C1 und DE 10 2006 044 778 A1 bekannt.

Derartige Sensorelektroden können verwendet werden, um eine Tür oder Klappe eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten.

Aus der WO 2010/095513 A1 ist eine Schaltung zur Erfassung von Kapazitätsänderungen einer Sensorelektrode bekannt. Eine Baugruppe mit veränderlicher Kompensationskapazität kann für jeden Meßzyklus nach dem Aufladen einer Sensorelektrode und nach dem Entkoppeln der Sensorelektrode von der Spannungsquelle für einen Ladungstransfer einer Teil-Ladung mit der Sensorelektrode gekoppelt werden. Dies dient der Erhöhung der Empfindlichkeit der Erfassung, da ein konstanter Ladungsanteil vor der Messung von der Sensorelektrode abgezogen wird.

Ein Problem mit den bekannten Einrichtungen besteht darin, dass die Sensorelektroden mit unterschiedlichen kapazitiven Lasten konfrontiert werden. Veränderungen der Umgebungsbedingungen, z.B. Salzverkrustungen, Verschmutzungen, Nässe oder Dämpfe im Erfassungsbereich beeinflussen die Erfassungsgenauigkeit.

Aufgabe der Erfindung ist es daher, eine verlässliche Sensorik bereitzustellen, welche die Fehlerfassungen von Betätigungsanforderungen reduziert.

Erfindungsgemäß wird diese Aufgabe durch eine kapazitive Sensoranordnung mit den Merkmalen des Anspruchs 1 sowie ein Verfahren mit den Merkmalen des Anspruch 6 gelöst.

Die erfindungsgemäße Sensoranordnung zur Erfassung von Bewegungsgesten an einem Kraftfahrzeug hat wenigstens eine kapazitive Sensorelektrode und wenigstens eine mit der Sensorelektrode gekoppelte Steuer- und Auswerteeinrichtung. Diese erfasst eine Zeitfolge von Kapazitätswerten der Sensorelektrode, wobei die Steuer- und Auswerteeinrichtung in Abhängigkeit von der Zeitfolge ein Betätigungssignal ausgibt, wenn eine Betätigung erkannt wird.

Als wesentliches Merkmal wird vorgeschlagen, durch die Steuer- und Auswerteeinrichtung in Abhängigkeit von den erfassten Kapazitätswerten veränderliche kapazitive Grundlasten zuzuschalten oder wegzuschalten. Mit der Steuer- und Auswerteeinrichtung ist dazu eine ansteuerbare Grundlastbaugruppe gekoppelt, mit der in Abhängigkeit von der Ansteuerung eine kapazitive Grundlast zur der durch die Sensorelektrode gebildeten kapazitiven Messlast hinzuschaltbar ist. Die die zugeschaltete (konstante) Grundlast ist zusammen mit der (betätigungsabhängigen) Messlast in der Steuer- und Auswerteeinrichtung als kapazitive Gesamtlast erfassbar.

Die Elektrodenanordnung wird mit der Steuer- und Auswerteeinrichtung auf eine vorgegebene Grundlast, also erfassbare Kapazität ausgelegt. Diese Grundlast wird erreicht, indem zuschaltbare kapazitive Lasten mit der Steuer- und Auswertevorrichtung gekoppelt werden, so dass die Kapazität der Sensorelektrode, zusammen mit den zugeschalteten kapazitiven Lasten durch die Steuer- und Auswertevorrichtung erfasst wird. Die Kapazitäten werden dazu der Sensorelektrode z.B. parallel geschaltet. Die Ansteuerung der Grundlastbaugruppe durch die Steuer- und Auswerteeinrichtung erfolgt in Abhängigkeit von der erfassten Gesamtlast.

Wird nun durch Umgebungseinflüsse die kapazitive Grundlast verändert, z.B. bei Salzverkrustungen des Stossfängers, in welchem die Sensorelektrode platziert ist, so kann durch Entkoppeln einer zugeschalteten Grundlast die Gesamtkapazität wieder in den Auslegungsbereich der Elektroden-Auswertungskombination zurückgeführt werden.

Wird die Salzverkrustung entfernt und die kapazitive Gesamtlast ändert sich wieder, wie durch die Messwerte jederzeit erfassbar ist, wird die kapazitive Grundlast durch Zuschaltung oder Einkopplung der Kapazitäten ebenfalls wieder in den Auslegungsbereich zurückgeführt.

Die Grundlastbaugruppe weist verschiedene zuschaltbare kapazitive Grundlasten auf, so dass in Abhängigkeit von der Ansteuerung eine veränderbare Grundlast hinzuschaltbar ist.

Als kapazitive Grundlast werden vorzugsweise Kondensatoren und Kombinationen von Kondensatoren verwendet, um die Grundlast schrittweise verändern zu können. Es können also mehrere Grundlastabstufungen vorgesehen und zuschaltbar sein.

Die Zuschaltung erfolgt in einfacher Weise über ein elektronisches Schaltelement, welches unter Ansteuerung der Steuer- und Auswerteeinrichtung die Kapazitäten galvanisch von der Kapazitätserfassung trennen kann.

Die Anpassung der kapazitiven Grundlast erfolgt in Abhängigkeit von Vorgängen, welche auf einer Zeitskala ablaufen, die um Größenordnungen länger als die mit der Sensoreinrichtung zu erfassenden Prozesse ist. Die Zuschaltung oder Abschaltung der Grundlast-Kapazitäten kann z.B. in Abhängigkeit von über Minuten gemittelten Kapazitätswerten erfolgen.

Wesentlich ist, dass die Sensoranordnung jederzeit im Sollbereich der erfassten Kapazität arbeitet, was eine Erkennungsgenauigkeit verbessert.

Vorzugsweise werden Kondensatoren als Grundlast eingesetzt, die durch Kombinationsschaltung einen weiten Bereich von Grundlasten einstellbar machen. Werden beispielsweise Kondensatoren in Kapazitätsverhältnissen von 2 zu 4 zu 8 zu 16 (also hier Potenzen von 2) eingesetzt, kann durch deren Kombinationsschaltung eine vielstufige Anpassung der Grundlast als Vielfaches einer kapazitiven Grundgröße erfolgen (im Beispiel 2, 4, 6, 8, 10, 12, 14, 16, 18, 20, 22, 24, 26, 28, 30) .

Wie bereits erwähnt, erfolgt die Zuschaltung der Grundlasten in Abhängigkeit vom Signal oder Hub der ermittelten Kapazitäten. In einer Grundstellung (Fahrzeug bei Normalbedingungen und im Normalzustand bei Auslieferung) können gemäß des vorgenannten z.B. Kapazitäten mit dem 14-fachen einer Grundgröße zugeschaltet sein.

So ist sowohl zur Erhöhung der Grundlast als auch zur Verringerung der Grundlast ausreichend Stellgröße verfügbar.

Die Sensorelektrode kann im Rahmen der Erfindung beliebig ausgebildet sein, so z.B. als langgestreckter Draht, Koaxialleiteranordnung oder auch Flachelektrode. Außerdem kann die Elektrode mehrteilig ausgebildet sein. Die Sensorelektrode besteht immer aus einem elektrisch leitenden Material.

Die erfindungsgemäße kapazitive Sensoranordnung umfasst demnach eine sich entlang einer ersten Koordinatenlinie erstreckende erste Sensorelektrode, mit deren Hilfe das Eindringen eines Objekts in einen Raum vor der ersten Sensorelektrode erfasst werden soll. Die Koordinatenlinie ist beispielsweise eine gerade Koordinatenlinie eines kartesischen Koordinatensystems; sie kann aber auch im Raum gekrümmt sein.

Eine elektrisch isolierende Ummantelung der Sensorelektrode kann vorgesehen sein. Dieses schützt vor Umwelteinflüssen und vor elektrischem Kontakt mit elektrisch leitenden Bauteilen.

Die gekoppelte Steuer- und Auswerteschaltung erfasst eine Änderung der Kapazität der Sensorelektrode gegenüber einem Referenzpotential, indem sie die erste Sensorelektrode mit einer vorgegebenen Frequenz periodisch auf- und entlädt und wenigstens einen Parameter eines vom periodischen Laden und Entladen der ersten Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungs-Potenzial, koppelt. Der Spannungsverlauf kann beispielsweise der Spannungsverlauf am Anschluss der ersten Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der ersten Sensorelektrode gemessene Spannung sein. Eine vorgegebene Geste eines Benutzers, z.B. ein angetäuschter Kick unter den Stossfänger, soll zu einem Öffnungs- oder Schließvorgang führen. Dazu wird die Sensorelektrode abgefragt, ob das zeitliche Signalmuster charakteristisch für eines solche Bewegung ist, im genannten Beispiel also eine Annäherung des Unterschenkels eines Benutzers detektiert und zu ansteigenden Signalwerten führt.

Die erfindungsgemäß zugeschalteten Grundlasten werden als Offset der Kapazität mit registriert. Es ist jedoch möglich, die Erfassung von Kapazitätsveränderungen auf einen schmalen Kapazitätsbereich abzustimmen und dort empfindlicher zu gestalten, da im Gegensatz zu bekannten Einrichtungen die Grundlast oder der Offset einstellbar ist.

Gemäß dem erfindungsgemäßen Verfahren wird der Betrieb einer Sensoranordnung zur Erfassung von Bewegungsgesten an einem Kraftfahrzeug, mit wenigstens einer kapazitiven Sensorelektrode und einer mit der Sensorelektrode gekoppelten Steuer- und Auswerteeinrichtung offenbart. Diese Steuer- und Auswerteeinrichtung erfasst eine Zeitfolge von Kapazitätswerten der Sensorelektrode, wobei die Steuer- und Auswerteeinrichtung in Abhängigkeit von der Zeitfolge ein Betätigungssignal ausgibt.

Im Rahmen des Verfahrens wird zyklisch eine kapazitive Gesamtlast erfasst, und zwar mit einer mit der Sensorelektrode gekoppelten Steuer- und Auswerteeinrichtung. Diese erfasste kapazitive Gesamtlast wird mit einem vorgegebenen Last-Sollwert verglichen, auf welchen die Steuer- und Auswerteeinrichtung ausgelegt ist.

In Abhängigkeit von dem Vergleich, also in Abhängigkeit davon, ob die Gesamtlast über oder unter dem Sollwert liegt, wird eine kapazitive Grundlast zur einer durch die Sensorelektrode gebildeten kapazitiven Messlast hinzugekoppelt oder entkoppelt, so dass die zugeschaltete (konstante) Grundlast zusammen mit der (veränderbaren und betätigungsanzeigenden) Messlast in der Steuer- und Auswerteeinrichtung als kapazitive Gesamtlast erfasst wird. Entsprechend wird also die Grundlast in Abhängigkeit von der erfassten Gesamtlast gewählt, um die Gesamtlast dem vorgegeben Last-Sollwert anzunähern.

Vorteilhafte und/oder bevorzugte Ausführungsformen sind in den Unteransprüchen gekennzeichnet.

Die Erfindung wird nun anhand der beiliegenden Figuren näher erläutert.
Figur 1 zeigt die Anordnung einer Ausführungsform der erfindungsgemäßen Sensoranordnung an einem Kraftfahrzeug;
Figur 2 zeigt die Anordnung aus Figur 1 in einer schematischen Aufsicht;
Figur 3 zeigt ein Blockschaltbild einer erfindungsgemäßen Sensoranordnung;

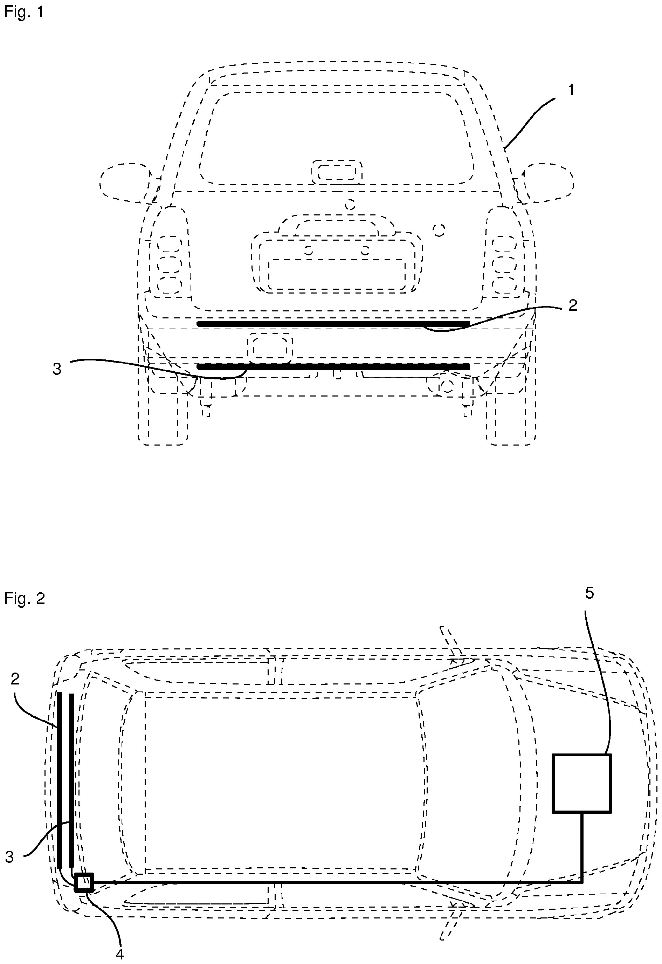

In Figur 1 ist das Heck eines Fahrzeugs 1 gezeigt. Bereich des Heckstossfängers ist eine Sensorelektrodenanordnung 2 angebracht. Unterhalb der Sensorelektrodenanordnung 2 ist eine weitere Sensorelektrodenanordnung 3 mit einem vertikalen und horizontalen Versatz angeordnet. Die Sensorelektrodenanordnungen 2 und 3 sind mit einer Steuer- und Auswerteeinrichtung 4 verbunden. Diese ist nahe der Elektroden 2 und 3 angeordnet. Die Einrichtung 4 ist wiederum mit einer zentralen Fahrzeugsteuereinheit 5 gekoppelt (siehe Figur 2). Die zentrale Steuereinrichtung 5 erhält von der Steuer- und Auswerteeinrichtung 4 ein Signal zur Öffnung der Heckklappe, wobei die Einrichtung 4 die Signale der Elektroden auswertet. Die Elektroden 2, 3 werden auch über diese Steuer- und Auswerteeinrichtung 4 aufgeladen und deren Kapazitätsänderung bei Annäherung eines Körpers, z.B. eines Bedienerkörperteils wird durch Ladungsauswertung erfasst.

Sowohl mittels der ersten kapazitiven Sensorelektrode 2 als auch mittels der zweiten kapazitiven Sensorelektrode 3 wird eine jeweilige Kapazität zwischen der jeweiligen Elektrode 2, 3 und der Fahrbahn gemessen. Sollte sich diese Kapazität verändern, beispielsweise indem ein Gegenstand zwischen die jeweilige Elektrode 2, 3 und die Fahrbahn gerät, wird diese Änderung der Kapazität für die jeweilige Elektrode 2, 3 durch die Steuer- und Auswerteeinrichtung 4, in welcher die beiden Elektroden 2, 3 zusammenlaufen, erfasst.

Aufgrund des Abstands der beiden Elektroden 2, 3 kann eine Bewegungsanalyse beispielsweise eines Fußes durchgeführt werden, welcher sich zwischen dem Heckstossfänger und der Fahrbahn bewegt. Demnach ist es durch die parallel verlegten Elektroden 2, 3 möglich, eine einfache Kickbewegung zum Öffnen oder Schließen der Heckklappe durchzuführen, ohne dass von dem Fahrer eine komplizierte Bedienabfolge erforderlich ist.

Aufgrund der beiden parallel verlegten Elektroden 2, 3 bilden die zwei Elektroden 2, 3 ein kapazitives Sensorarray, wodurch der Bedienablauf in zwei Bewegungen mit jeweils unterschiedlicher Richtung unterteilt werden kann. Bei der ersten Bewegung (Hinbewegung) bewegt sich der Fuß unter dem Heckstossfänger und bei der zweiten Bewegung (Rückbewegung) wird der Fuß von der Bedienperson zurückgezogen. Erkennt die erfindungsgemäße Vorrichtung 4 über die kapazitiven Sensorelektroden 2, 3 die Bewegung, indem zuerst die erste kapazitive Sensorelektrode 2 und anschließend die zweite kapazitive Sensorelektrode 3 anspricht, so wird ein dem Fahrzeug zugeordneter Schlüssel oder Funkchip per Funkdialog abgefragt, indem von einer Antenne, insbesondere im Heckbereich des Fahrzeugs, ein Funksignal ausgestrahlt wird. Befindet sich der Schlüssel im Empfangsbereich der Antenne, sendet er seinerseits ein Funksignal aus, welches schließlich auf Fahrzeugseite erfasst wird. In diesem Fall kann die Heckklappe geöffnet werden.

Dieses Prinzip eines kapazitiven Sensors ist im Bereich der Kraftfahrzeugtechnik bekannt. Der Verbund aus Elektroden 2, 3 und Steuer- und Auswerteeinrichtung 4 absolviert also die Erfassung und Auswertung von Signalen selbstständig und liefert ein Öffnungssignal.

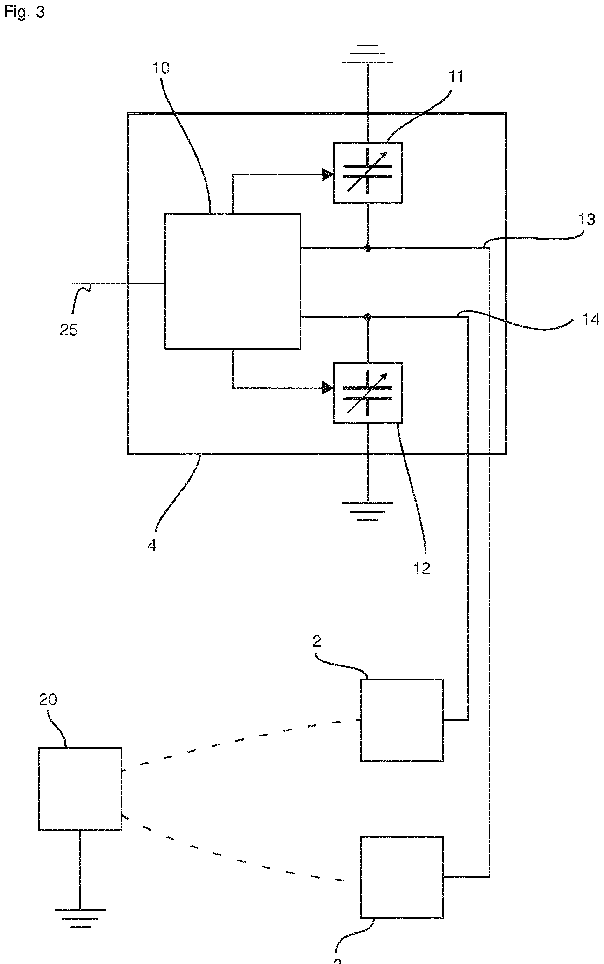

Figur 3 zeigt, dass in der Steuer- und Auswerteeinrichtung 4 die erfindungswesentlichen Merkmale realisiert sind. Die Steuer- und Auswerteeinrichtung 4 enthält einen Mikrocontroller 10 und zwei mit dem Mikrocontroller gekoppelte, schaltbare Kondensatoranordnungen 11 und 12. Die Kondensatoranordnungen 11 und 12 weisen jeweils schaltbare Kapazitäten auf, die zwischen Zuleitungen 13 und 14 zu Masse schaltbar sind. Die Zuleitungen 13 und 14 sind jeweils mit Eingangsports des Mikrocontrollers 10 gekoppelt. Die schematisch gezeigte Außenelektrode 2 ist über die Zuleitung 14 mit einem Eingang des Mikrocontrollers 10 gekoppelt ist, wobei mittels der Kondensatoranordnung 12 eine vorwählbare Kapazität zuschaltbar ist. Entsprechend ist die Sensorelektrode 3 über die Zuleitung 13 mit einem Eingangsport des Mikrocontrollers 10 gekoppelt, wobei eine zusätzliche Kapazität in der Kondensatoranordnung 11 vorwählbar ist. Der Mikrocontroller 10 erfasst die Kapazitäten, welche an den entsprechenden Eingangsports ermittelbar sind. Die Ansteuerung der Kondensatoranordnungen, also die Zuschaltung oder Entkopplung der Kondensatoren erfolgt durch Ansteuerung des Mikrocontrollers 10, in Abhängigkeit von den an den Zuleitungen 13 und 14 erfassten Kapazitäten. Jede der Kondensatoranordnungen 11 und 12 enthält mehrere Kondensatoren, die in Kombination oder einzeln zugeschaltet werden können.

In Figur 3 ist dargestellt, dass die Elektroden 2 und 3 eine Kapazität gegenüber einer Masseverbundenen Gegenelektrode 20 bilden. Diese Elektrode kann durch den Boden im Kraftfahrzeugbereich gebildet sein oder durch einen sich annähernden Nutzer oder auch eine Mischung verschiedener geerdeter Körper im Erfassungsbereich. Die zwischen der Elektrode 2 und der Elektrode 20 gebildete Kapazität wird zusammen mit der eingestellten Grundlast in Gestalt der eingestellten Kapazität der Kondensatoranordnung 12 gemessen. Die Kapazität zwischen der Elektrode 20 und der Elektrode 3 wird zusammen mit der Kapazität der Anordnung 11 gemessen.

Ändert sich nun in der Umgebung der Elektroden 2 und 3 das umgebende Dielektrikum, also insbesondere im Zwischenbereich zwischen diesen Elektroden 2 und 3 und der Gegenelektrode 20, so ändert sich auch diese Grundkapazität. Wird beispielsweise ein zwischen Elektrode und Erfassungsbereich befindliches Karosserieelement verschmutzt oder mit einer Salzkruste überzogen, so werden die Elektroden 2 und 3 eine andere Grundkapazität aufweisen als in einem trockenen und gereinigten Zustand des Fahrzeuges. Der Mikrocontroller 10 registriert in wiederholten Zeitabständen die erfassten Kapazitäten und sorgt durch Einstellung, d. h. durch Kopplung von Kondensatoren in der Einrichtung 11 und 12 dafür, dass die Mittelwerte der erfassten Kapazitäten über längere Zeiträume in einem gewünschten Erfassungsbereich liegen. Erhöht sich also beispielsweise die Kapazität zwischen der Elektrode 2 und der Elektrode 20 durch Umgebungseinflüsse, so wird die zugeschaltete Kapazität der Einrichtung 12 verringert. Kurzzeitige Signalveränderungen und Kapazitätsveränderungen, wie sie bei der Auswertung von Betätigungsgesten zu erfassen sind, haben keinen Einfluss auf die vorgewählten Kapazitätswerte in den Einrichtungen 11 und 12. Stattdessen wird die Kapazitätsanpassung auf Basis gleitender Mittelwerte über längere Zeitbereich, z.B. einige Minuten vorgenommen. Die Erfindung ermöglicht die Feinabstimmung einer Signalerfassung und -auswertung auf einen vorgegebenen Kapazitätsbereich. Durch die zuschaltbaren Grundkapazitäten bzw. Grundlasten kann dafür gesorgt werden, dass die Erfassung jederzeit von einer Grundkapazität ausgeht, die in dem vorgegebenen Erfassungsbereich liegt. Die Sensibilität dieser Anordnung kann daher gegenüber herkömmlichen Anordnungen, die große Kapazitätsbereiche erfassen muss, deutlich erhöht werden.

Nach Auswertung der Signale liefert der Controller 10 über einen Ausgang 25 an die zentrale Fahrzeugsteuereinrichtung 5 ein Öffnungssignal, sofern eine Betätigung erfasst wurde.

Im Rahmen der Erfindung können mehrere Kondensatoren als Grundlast schaltbar sein, es kann jedoch auch ein einziger Kondensator zu einer oder zu beiden Elektroden zuschaltbar sein.

## Patentansprüche

1. Sensoranordnung zur Erfassung von Bewegungsgesten an einem Kraftfahrzeug, mit wenigstens einer kapazitiven Sensorelektrode (2, 3) und einer mit der Sensorelektrode gekoppelten Steuer- und Auswerteeinrichtung (4), die eine Zeitfolge von Kapazitätswerten der Sensorelektrode erfasst, wobei die Steuer- und Auswerteeinrichtung in Abhängigkeit von der Zeitfolge ein Betätigungssignal ausgibt, wobei mit der Steuer- und Auswerteeinrichtung eine ansteuerbare Grundlastbaugruppe (11, 12) gekoppelt ist, mit der in Abhängigkeit von der Ansteuerung eine kapazitive veränderliche Grundlast zur der durch die Sensorelektrode (2, 3) gebildeten kapazitiven Messlast hinzukoppelbar oder entkoppelbar ist, **dadurch gekennzeichnet, dass** die zugeschaltete veränderliche Grundlast zusammen mit der Messlast in der Steuer- und Auswerteeinrichtung (4) als kapazitive Gesamtlast erfasst wird,
wobei die Steuer- und Auswerteeinrichtung zur zeitlichen Mittelung der erfassten Gesamtlast ausgebildet ist,
wobei die Ansteuerung der Grundlastbaugruppe (11, 12) durch die Steuer- und Auswerteeinrichtung zur Veränderung der Grundlast in Abhängigkeit von dem Mittelwert der erfassten Gesamtlast derart erfolgt, dass die erfasste Gesamtlast jederzeit in einem Sollbereich liegt, auf welchen die Sensorelektrode mit der Steuer- und Auswerteeinrichtung ausgelegt ist.

2. Sensoranordnung nach Anspruch 1, wobei die Grundlastbaugruppe verschiedene zuschaltbare kapazitive Grundlasten aufweist, so dass in Abhängigkeit von der Ansteuerung eine veränderbare Grundlast hinzuschaltbar ist.

3. Sensoranordnung nach Anspruch 1 oder 2, wobei mehrere Sensorelektroden (2, 3) vorgesehen sind, die mit einer Grundlastbaugruppe (11, 12) koppelbar sind.

4. Sensoranordnung nach Anspruch 3, wobei jeder Sensoranordnung eine eigene Grundlastbaugruppe (11, 12) zugeordnet ist, wobei die jeweiligen Grundlastbaugruppen von der Steuer- und Auswerteeinrichtung getrennt ansteuerbar sind.

5. Sensoranordnung nach einem der Ansprüche 1, 2 und 4, wobei die kapazitive Grundlast parallel zu der Sensorelektrode, zwischen Steuer- und Auswerteeinrichtung und Masse erfolgt.

6. Verfahren zum Betrieb einer Sensoranordnung zur Erfassung von Bewegungsgesten an einem Kraftfahrzeug, mit wenigstens einer kapazitiven Sensorelektrode (2, 3) und einer mit der Sensorelektrode gekoppelten Steuer- und Auswerteeinrichtung (4), die eine Zeitfolge von Kapazitätswerten der Sensorelektrode erfasst, wobei die Steuer- und Auswerteeinrichtung in Abhängigkeit von der Zeitfolge ein Betätigungssignal ausgibt
mit den Schritten
Erfassen einer kapazitiven Gesamtlast, vermittels einer mit der Sensorelektrode gekoppelten Steuer- und Auswerteeinrichtung;
Bestimmen eines zeitlichen Mittelwertes der erfassten kapazitiven Gesamtlast;
Vergleichen des zeitlichen Mittelwertes der erfassten kapazitiven Gesamtlast mit einem vorgegebenen Last-Sollwert, auf welchen die Steuer- und Auswerteeinrichtung ausgelegt ist;
Koppeln einer kapazitiven veränderlichen Grundlast zur einer durch die Sensorelektrode (2, 3) gebildeten kapazitiven Messlast, so dass die zugeschaltete Grundlast zusammen mit der Messlast in der Steuer- und Auswerteeinrichtung (4) als kapazitive Gesamtlast erfasst wird,
wobei die Grundlast in Abhängigkeit von dem Mittelwert der erfassten Gesamtlast verändert wird, um den Mittelwert der Gesamtlast dem vorgegeben Last-Sollwert derart anzunähern, dass die erfasste Gesamtlast jederzeit in einem Sollbereich liegt, auf welchen die Sensorelektrode mit der Steuer- und Auswerteeinrichtung ausgelegt ist.

## Claims

1. Sensor arrangement for detecting movements on a motor vehicle, having at least one capacitive sensor electrode (2, 3) and one control and evaluation device (4) coupled with the sensor electrode, which device detects a time sequence of capacitive values of the sensor electrode, wherein the control and evaluation device generates an actuation signal depending on the time sequence, wherein a controllable base load subassembly (11, 12) is coupled with the control and evaluation device, with which subassembly, depending on the control, a capacitive variable base load can be coupled to or decoupled from the capacitive measuring load formed by the sensor electrode (2, 3), **characterized in that** the connected variable base load is detected together with the measuring load in the control and evaluation device (4) as capacitive overall load, wherein the control and evaluation device is designed for the time averaging of the detected overall load, wherein the base load subassembly (11, 12) is controlled by the control and evaluation device for changing the base load depending on the average of the detected overall load in such a manner that the detected overall load is in a desired range at all times, on which the sensor electrode is designed with the control and evaluation device.

2. Sensor arrangement according to Claim 1, wherein the base load subassembly has different connectable capacitive base loads, such that a variable base load can be switched depending on the control.

3. Sensor arrangement according to Claim 1 or 2, wherein a plurality of sensor electrodes (2, 3) are provided, which can be coupled with a base load subassembly (11, 12) .

4. Sensor arrangement according to Claim 3, wherein an individual base load subassembly (11, 12) is assigned to each sensor arrangement, wherein the respective base load subassemblies can be controlled separately by the control and evaluation device.

5. Sensor arrangement according to one of Claims 1, 2 and 4, wherein the capacitive base load takes place parallel to the sensor electrode, between the control and evaluation device and mass.

6. Method for operating a sensor arrangement for detecting movements on a motor vehicle, having at least one capacitive sensor electrode (2, 3) and one control and evaluation device (4) coupled with the sensor electrode, which device detects a time sequence of capacitive values of the sensor electrode, wherein the control and evaluation device generates an actuation signal depending on the time sequence, having the steps of detecting a capacitive overall load, by means of a control and evaluation device coupled with the sensor electrode; determining a time average of the detected capacitive overall load; comparing the time average of the detected capacitive overall load with a predetermined load setpoint, on which the control and evaluation device is designed; coupling a capacitive variable base load to a capacitive measuring load formed by the sensor electrode (2, 3), such that the connected base load is detected together with the measuring load in the control and evaluation device (4) as capacitive overall load, wherein the base load is changed depending on the average of the detected overall load, in order to get the average of the overall load closer to the predetermined load setpoint in such a manner that the detected overall load is in a desired range at all times, on which the sensor electrode is designed with the control and evaluation device.

## Revendications

1. Système de capteur destiné à la saisie de gestes de mouvement sur un véhicule automobile, avec au moins une électrode de capteur capacitive (2, 3) et un dispositif de commande et d'exploitation (4) couplé à une électrode de capteur, qui saisit un ordre chronologique de valeurs de capacité de l'électrode de capteur, sachant que le dispositif de commande et d'exploitation émet un signal de commande en fonction de l'ordre chronologique,
sachant qu'au dispositif de commande et d'exploitation un module de charge de base (11, 12) pouvant être commandé est couplé, avec lequel une charge de base capacitive variable peut être en plus couplée à la charge de mesure capacitive formée par l'électrode de capteur (2, 3) ou découplée en fonction de la commande, **caractérisé en ce que**
la charge de base variable connectée est saisie avec la charge de mesure dans le dispositif de commande et d'exploitation (4) en tant que charge totale capacitive,
sachant que le dispositif de commande et d'exploitation est constitué pour la formation de la moyenne temporelle de la charge totale saisie,
sachant que la commande du module de charge de base (11, 12) a lieu par le dispositif de commande et d'exploitation pour modifier la charge de base en fonction de la moyenne de la charge totale saisie de telle manière que la charge totale saisie se situe à tout moment dans une zone théorique à laquelle l'électrode de capteur est conçue avec le dispositif de commande et d'exploitation.

2. Système de capteur selon la revendication 1, sachant que le module de charge de base comporte différentes charges de base capacitives connectables de telle manière qu'une charge de base variable peut être connectée en plus en fonction de la commande.

3. Système de capteur selon la revendication 1 ou 2, sachant que plusieurs électrodes de capteur (2, 3) sont prévues, qui peuvent être couplées à un module de charge de base (11, 12).

4. Système de capteur selon la revendication 3, sachant qu'un module de charge de base propre (11, 12) est attribué à chaque système de capteur, sachant que les modules de charge de base respectifs peuvent être activés séparément du dispositif de commande et d'exploitation.

5. Système de capteur selon l'une des revendications 1, 2 et 4, sachant que la charge de base capacitive a lieu parallèlement à l'électrode de capteur entre le dispositif de commande et d'exploitation et la masse.

6. Procédé destiné à faire fonctionner un système de capteur pour la saisie de gestes de mouvement sur un véhicule automobile, avec au moins une électrode de capteur capacitive (2, 3) et un dispositif de commande et d'exploitation (4) couplé à l'électrode de capteur, qui saisit un ordre chronologique de valeurs de capacité de l'électrode de capteur, sachant que le dispositif de commande et d'exploitation émet un signal de commande en fonction de l'ordre chronologique,
avec les étapes de
saisie d'une charge totale capacitive au moyen d'un dispositif de commande et d'exploitation couplé à l'électrode de capteur,
détermination d'une valeur moyenne temporelle de la charge totale capacitive saisie,
comparaison de la valeur moyenne temporelle de la charge totale capacitive saisie à une valeur théorique de charge prédéfinie à laquelle le dispositif de commande et d'exploitation est conçu,
couplage d'une charge de base capacitive variable à une charge de mesure capacitive formée par l'électrode de capteur (2, 3) de telle manière que la charge de base connectée est saisie avec la charge de mesure dans le dispositif de mesure et d'exploitation (4) en tant que charge totale capacitive,
sachant que la charge de base est modifiée en fonction de la valeur moyenne de la charge totale saisie pour rapprocher la valeur moyenne de la charge totale de la valeur théorique de charge prédéfinie de telle manière que la charge totale saisie se situe à tout moment dans une zone théorique à laquelle l'électrode de capteur est conçue avec le dispositif de commande et d'exploitation.
